(19) Europäisches Patentamt
European Patent Office
Office européen des brevets

(11) EP 4 317 495 A1

(12) **EUROPEAN PATENT APPLICATION**
published in accordance with Art. 153(4) EPC

(43) Date of publication:
**07.02.2024 Bulletin 2024/06**

(21) Application number: **21935154.1**

(22) Date of filing: **29.11.2021**

(51) International Patent Classification (IPC):
***C22C 13/00*** (2006.01) ***B23K 35/14*** (2006.01)
***B23K 35/26*** (2006.01) ***B23K 35/363*** (2006.01)
***H05K 3/34*** (2006.01)

(52) Cooperative Patent Classification (CPC):
**B23K 35/0205; B23K 35/26; B23K 35/3601; C22C 13/00; H05K 3/34**

(86) International application number:
**PCT/JP2021/043559**

(87) International publication number:
**WO 2022/209001 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2021 JP 2021060952**

(71) Applicant: **Senju Metal Industry Co., Ltd.**
**Tokyo 120-8555 (JP)**

(72) Inventors:
- **MURAOKA, Manabu**
  **Tokyo 120-8555 (JP)**
- **HIRAOKA, Miyuki**
  **Tokyo 120-8555 (JP)**
- **KIMURA, Nobuhito**
  **Tokyo 120-8555 (JP)**

(74) Representative: **Pfenning, Meinig & Partner mbB**
**Patent- und Rechtsanwälte**
**Theresienhöhe 11a**
**80339 München (DE)**

# (54) FLUX FOR FLUX-COATED SOLDER PREFORM, FLUX-COATED SOLDER PREFORM, AND METHOD FOR MOUNTING ELECTRONIC COMPONENTS ON ELECTRONIC SUBSTRATE

(57) An objective of the present invention is to provide a flux for flux-coated solder preform, a flux-coated solder preform, and a method for mounting an electronic component on an electronic substrate using the flux-coated solder preform, having good workability in drawing out a flux-coated solder preform from a reel, being free from misalignment of an electronic component during reflow soldering,. The flux for flux-coated solder preform has a softening point of 80 to 120°C.

Fig. 1

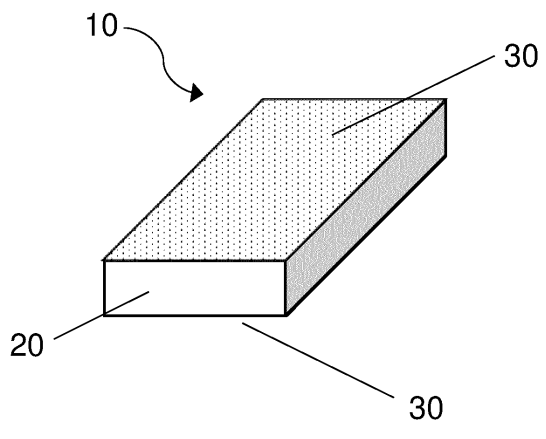


EP 4 317 495 A1

## Description

TECHNICAL FIELD

The present invention relates to a flux for flux-coated solder preform, a flux-coated solder preform, and a method for mounting electronic components on an electronic substrate.

BACKGROUND ART

Fixing and electrical connection of electronic components in electronic devices, such as mounting of the electronic components on printed circuit boards, are generally performed by soldering, which is the most advantageous in terms of costs and reliability.

The methods commonly employed for this type of soldering are a flow soldering method, in which the printed circuit boards and the electronic components are soldered by bringing them into contact with molten solder, and a reflow soldering method, in which solder in a form of solder preform, solder paste, or solder ball is re-melted in a reflow oven to perform the soldering.

In the soldering, a flux is used as an auxiliary agent that makes it easier for the solder to adhere to the printed circuit boards and the electronic components. The flux performs a number of useful actions, including a metal surface cleaning action, an anti-reoxidation action and an interface tension reduction action.

The solder preform used in the reflow soldering method is a solid solder formed in advance, having various shapes.

One of the solder preforms is a flux-coated solder preform, which is made by applying a flux to the surface of a solder preform and drying the flux to provide a flux coating layer in advance. Use of the flux-coated solder preform has advantages, such as allowing a flux application step in soldering to be omitted, and allowing solder and flux to be surely supplied to a spot such as concave portion into which solder paste or flux is hardly supplied. As a result, use of a flux-coated solder preform allows soldering to be performed efficiently.

In the case where a flux-coated solder preform has a ribbon shape (tape or long and thin band), the flux-coated solder preform is wound on a reel to be stored in general. A flux-coated solder preform may have a flux coating layer on both the upper and lower faces of the flux-coated solder preform. In the case where such a flux-coated solder preform is wound on a reel, the flux coating layers are contacted with each other between the neighboring flux-coated solder preforms. In the case where the surface of the flux coating layer has an excessively high adhesive force during storage, the neighboring flux coating layers stick to each other during storage of the preform wound on a reel, so that workability is lowered in drawing out the flux-coated solder preform from the reel.

Further, when the reflow soldering method is performed, the flux-coated solder preform is placed under high temperature. In the case where the flux coating layer has a small adhesive force under the high temperature, the degree of temporary fixation of electronic components to a printed circuit board during reflow soldering is insufficient, so that misalignment of electronic components occurs.

As a conventional flux-coated solder preform, in PTL 1, a component pre-coated with a flux containing a first ingredient and a second ingredient in an amount effective for adding flexibility after accumulation is shown.

CITATION LIST

PATENT LITERATURE

PTL 1: JP 2010-515576 A

SUMMARY OF INVENTION

TECHNICAL PROBLEM

The conventional flux-coated solder preform as described in PTL 1 takes no consideration of the workability in drawing out a flux-coated solder preform from a reel and the misalignment of electronic components during reflow soldering as described above.

As described above, a flux-coated solder preform having good workability in drawing out the flux-coated solder preform from a reel, being free from misalignment of electronic components during reflow soldering, has been desired.

An object of the present invention is to provide a flux for flux-coated solder preform, a flux-coated solder preform, and a method for mounting electronic components on an electronic substrate using the flux-coated solder preform, having good workability in drawing out the flux-coated solder preform from a reel, being free from misalignment of electronic components during reflow soldering.

SOLUTION TO PROBLEM

As a result of intensive studies to solve the above problem, the present inventors have found that the above problem can be solved by using a flux for flux-coated solder preform having a specific softening point, or a flux-coated solder preform having a flux coating layer having a specific softening point, and have completed the present invention. Specific embodiments of the present invention are as follows.

Here, in the present description, when representing a numerical value range by using "X to Y", its range includes numerical values X and Y at both ends.

[1] A flux for flux-coated solder preform, having a softening point of 80 to 120°C.

[2] The flux according to item [1], wherein the flux comprises a rosin-based resin comprising a hydrogenated acid-modified rosin and a hydrogenated rosin, and
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux is 0.2 to 35.

[3] A flux-coated solder preform comprising

a solder preform and a flux coating layer present on a surface of the solder preform,
wherein the flux coating layer has a softening point of 80 to 120°C.

[4] The flux-coated solder preform according to item [3], wherein the flux coating layer has a tack strength of 0.98 N (100 gf) or more measured under conditions of 130°C, and a tack strength of 0.98 N (100 gf) or less measured under conditions of 80°C.

[5] A flux-coated solder preform comprising

a solder preform and a flux coating layer present on a surface of the solder preform,
wherein the flux coating layer has a tack strength of 0.98 N (100 gf) or more measured under conditions of 130°C, and a tack strength of 0.98 N (100 gf) or less measured under conditions of 80°C.

[6] The flux-coated solder preform according to any one of items [3] to [5],

wherein the flux coating layer comprises a rosin-based resin comprising a hydrogenated acid-modified rosin and a hydrogenated rosin, and
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux coating layer is 0.2 to 35.

[7] The flux-coated solder preform according to any one of items [3] to [6], wherein a content of the flux coating layer based on the whole flux-coated solder preform is 0.1 to 12 mass%.

[8] The flux-coated solder preform according to any one of items [3] to [7],

wherein the flux coating layer further comprises an organic acid, and
a ratio of a content of the organic acid (mass%) to a content of the rosin-based resin (mass%) (Organic acid content (mass%)/Rosin-based resin content (mass%)) in the flux coating layer is more than 0 and 0.15 or less.

[9] The flux-coated solder preform according to any one of items [3] to [8],

wherein the flux coating layer further comprises an amine, and
a ratio of a content of the amine (mass%) to a content of the rosin-based resin (mass%) (Amine content (mass%)/Rosin-based resin content (mass%)) in the flux coating layer is more than 0 and 0.1 or less.

[10] The flux-coated solder preform according to any one of items [3] to [9],

wherein the flux coating layer further comprises an amine hydrohalide, and
a ratio of a content of the amine hydrohalide (mass%) to a content of the rosin-based resin (mass%) (Amine hydrohalide content (mass%)/Rosin-based resin content (mass%)) in the flux coating layer is more than 0 and 0.2 or less.

[11] The flux-coated solder preform according to any one of items [3] to [10],

wherein the flux coating layer further comprises an organic bromine compound, and
a ratio of a content of the organic bromine compound (mass%) to a content of the rosin-based resin (mass%) (Organic bromine compound content (mass%)/Rosin-based resin content (mass%)) in the flux coating layer is more than 0 and 0.12 or less.

[12] A method for mounting an electronic component on an electronic substrate comprising:

a step of disposing the flux-coated solder preform according to any one of items [3] to [11] on the electronic substrate and disposing the electronic component on the flux-coated solder preform so as to form a laminate comprising the electronic substrate, the flux-coated solder preform and the electronic component, and
a step of heating the laminate to melt the flux coating layer and the solder preform and then cooling the laminate to solidify the solder preform for bonding the electronic substrate to the electronic component.

[13] The flux according to item [1] or [2],

wherein the flux comprises a rosin-based resin consisting of a hydrogenated acid-modified rosin and a hydrogenated rosin,
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux is 0.2 to 35,
the content of the hydrogenated acid-modified rosin (mass%) is 8 mass% or more and 50 mass% or less and the content of the hydrogenated rosin (mass%) is 1 mass% or more and 40 mass% or less based on the whole flux, and
the flux comprises no resin other than the rosin-based resin.

[14] The flux-coated solder preform according to any one of items [3] to [11],

wherein the flux coating layer has a tack strength of 0.98 N (100 gf) or more measured under conditions of 130°C, and a tack strength of 0.98 N (100 gf) or less measured under conditions of 80°C,
the flux coating layer comprises a rosin-based resin consisting of a hydrogenated acid-modified rosin and a hydrogenated rosin,
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux coating layer is 0.2 to 35,
the content of the hydrogenated acid-modified rosin (mass%) is 15 mass% or more and 85.8 mass% or less and the content of the hydrogenated rosin (mass%) is 2 mass% or more and 85 mass% or less based on the whole flux coating layer, and
the flux coating layer comprises no resin other than the rosin-based resin.

[15] A method for mounting an electronic component on an electronic substrate comprising:

a step of disposing the flux-coated solder preform according to item [14] on the electronic substrate and disposing the electronic component on the flux-coated solder preform so as to form a laminate comprising the electronic substrate, the flux-coated solder preform and the electronic component, and
a step of heating the laminate to melt the flux coating layer and the solder preform and then cooling the laminate to solidify the solder preform for bonding the electronic substrate to the electronic component.

[16] Use of the flux according to item [1], [2] or [13] for a flux-coated solder preform.

ADVANTAGEOUS EFFECTS OF INVENTION

The flux for flux-coated solder preform, the flux-coated solder preform, and the method for mounting electronic components on an electronic substrate using the flux-coated solder preform of the present invention achieve good workability in drawing out the flux-coated solder preform from a reel, being free from misalignment of electronic components during reflow soldering.

BRIEF DESCRIPTION OF DRAWINGS

[Fig. 1] Fig. 1 is a perspective view showing a flux-coated solder preform of the present invention.
[Fig. 2] Fig. 2 is a schematic view showing a procedure for mounting electronic components on an electronic substrate using the flux-coated solder preform of the present invention.
[Fig. 3] Fig. 3 is a schematic view of a QFN constituting a sample for evaluation of misalignment in Example seen from the lower face side (printed circuit board side).
[Fig. 4] Fig. 4 is a schematic view of a printed circuit board constituting a sample for evaluation of misalignment in Example seen from the upper face side (electronic component side).
[Fig. 5] Fig. 5 is a cross-sectional view showing a sample used for evaluation of misalignment in Example.
[Fig. 6] Fig. 6 is a graph showing a temperature profile during reflow soldering in Example.
[Fig. 7] Fig. 7 is an example of an X-ray photograph showing the soldering state of a sample after reflow soldering.

DESCRIPTION OF EMBODIMENTS

Hereinafter, a flux for flux-coated solder preform, a flux-coated solder preform, and a method for mounting electronic components on an electronic substrate of the present invention are described with reference to drawings.

[Flux for flux-coated solder preform]

The flux for flux-coated solder preform of the present invention may be used for forming a flux coating layer in a flux-coated solder preform to be described later.

The flux has a softening point of 80 to 120°C. With the softening point of the flux in the numerical value range, the flux coating layer in a flux-coated solder preform has an adhesiveness in an appropriate range, so that the workability in drawing out the flux-coated solder preform from a reel is improved and misalignment of electronic components during reflow soldering is suppressed. The softening point of the flux may be 80°C, 82°C, 84°C, 87°C, 90°C, 92°C, 94°C, 97°C, 100°C, 103°C, 106°C, 109°C, 112°C, 113°C, 114°C, 115°C, 116°C, 118°C, or 120°C, or may be in the range between any two of the numerical values. The softening point of the flux may be measured by the method to be described in "Examples" described below. As the samples for measurement of the softening point of the flux, a sample obtained by collecting a part of the flux coating layer of a flux-coated solder preform may be used, or a coating film prepared by applying a flux as raw material of the flux coating layer on another substrate may be used.

It is preferable that the flux contain a hydrogenated acid-modified rosin and a hydrogenated rosin.

In the flux, the ratio of the content of the hydrogenated acid-modified rosin (mass%) to the content of the hydrogenated rosin (mass%) (Hydrogenated acid-modified rosin content (mass%)/Hydrogenated rosin content (mass%)) is not particularly limited, and preferably 0.2 to 35, more preferably 1.5 to 2.3. In the case where the ratio is less than the lower limit, the softening point of the flux decreases and the adhesiveness of the flux coating layer becomes too large, so that workability is lowered in drawing out the flux-coated solder preform from the reel. In the case where the ratio is more than the upper limit, the softening point of the flux increases and the adhesiveness of the flux coating layer becomes too small and the misalignment of electronic components occurs during reflow soldering. The ratio may be 0.2, 0.5, 1.0, 1.5, 1.6, 1.7, 1.8, 1.9, 2.0, 2.1, 2.2, 5, 10, 15, 20, 25, 30 or 35, or may be in the range between any two of the numerical values.

The content of the hydrogenated acid-modified rosin (mass%) based on the whole flux is not particularly limited. The lower limit thereof may be 8 mass% or more, 10 mass% or more, 15 mass% or more, or 20 mass% or more, and the upper limit thereof may be 50 mass% or less, 45 mass% or less, or 40 mass% or less. The content of the hydrogenated acid-modified rosin (mass%) may be in a numerical value range specified by combination of any of the upper limits and any of the lower limits.

The content of the hydrogenated rosin (mass%) based on the whole flux is not particularly limited. The lower limit thereof may be 1 mass% or more, 3 mass% or more, 5 mass% or more, or 10 mass% or more, and the upper limit thereof may be 40 mass% or less, 35 mass% or less, 30 mass% or less, or 25 mass% or less. The hydrogenated rosin content (mass%) may be in a numerical value range specified by combination of any of the upper limits and any of the lower limits.

With the content of the hydrogenated acid-modified rosin (mass%) and the content of the hydrogenated rosin (mass%) in the numerical value ranges, respectively, the softening point of the flux may be adjusted to an appropriate range.

The hydrogenated rosin is not particularly limited, and a rosin that a raw material rosin such as gum rosin, wood rosin, and tall oil rosin is hydrogenated (hydrogenation) may be used.

The hydrogenated acid-modified rosin is not particularly limited, and a rosin that the raw material rosin described above is modified with an α,β-unsaturated carboxylic acid such as acrylic acid, maleic acid and fumaric acid, and then hydrogenated (hydrogenation) may be used.

The content of rosin-based resins other than hydrogenated acid-modified rosin and hydrogenated rosin (mass%) based on the whole flux is not particularly limited, and may be 0 mass% (not containing rosin-based resins other than hydrogenated acid-modified rosin and hydrogenated rosin). In this case, the rosin-based resin included in the flux is made of (consists of) hydrogenated acid-modified rosin and hydrogenated rosin. Here, "not containing" rosin-based resins other than hydrogenated acid-modified rosin and hydrogenated rosin means intentionally not adding the rosin-based resin as the flux component, and possibly containing the rosin-based resin as impurity of other components. Hereinafter, regarding another component also, the term "not containing" is used to mean intentionally not adding the other component, and possibly containing the other component as impurity.

The rosin-based resin other than hydrogenated acid-modified rosin and hydrogenated rosin is not particularly limited, and a raw material rosin such as gum rosin, wood rosin, and tall oil rosin, a derivative obtained from the raw material rosin (not including hydrogenated rosin), or a combination thereof may be used. Examples of the derivative include a refined rosin, a disproportionated rosin, or a polymerized rosin; a refined or disproportionated product of the polymerized rosin; and a refined or disproportionated product of the α,β-unsaturated carboxylic acid-modified product. One or two or more thereof may be used. In particular, an acrylic acid-modified rosin, a disproportionated rosin, a polymerized rosin, or a combination thereof is preferred.

The flux may or may not contain an organic acid. The organic acid has an effect for lowering the softening point of the flux, so that the softening point of the flux can be adjusted by adjusting the content of organic acid in the flux.

The ratio of the content of the organic acid (mass%) to the content of the rosin-based resin (mass%) (Organic acid content (mass%)/Rosin-based resin content (mass%)) in the flux is not particularly limited, and may be 0 or more and 0.15 or less or more than 0 and 0.15 or less. With a ratio in the numerical value range, the softening point of the flux can be adjusted to an appropriate range.

The content of the organic acid (mass%) based on the whole flux is not particularly limited, and may be 0 mass% or more and 0.7 mass% or less. With the content of the organic acid (mass%) in the numerical value range, the softening point of the flux can be adjusted to an appropriate range.

The organic acid is not particularly limited, and adipic acid, azelaic acid, eicosanedioic acid, citric acid, glycolic acid, glutaric acid, succinic acid, salicylic acid, diglycolic acid, dipicolinic acid, dibutylaniline diglycolic acid, suberic acid, sebacic acid, thioglycolic acid, terephthalic acid, dodecanedioic acid, para-hydroxy phenylacetic acid, palmitic acid, picolinic acid, phenyl succinic acid, phthalic acid, fumaric acid, maleic acid, malonic acid, lauric acid, benzoic acid, tartaric acid, tris(2-carboxyethyl)isocyanurate, glycine, 1,3-cyclohexanedicarboxylic acid, 2,2-bis (hydroxymethyl)propionic acid, 2,2-bis(hydroxymethyl)butanoic acid, 2,3-dihydroxybenzoic acid, 2,4-diethylglutaric acid, 2-quinolinecarboxylic acid, 3-hydroxybenzoic acid, malic acid, p-anisic acid, stearic acid, 12-hydroxystearic acid, oleic acid, linoleic acid, linolenic acid, dimer acid, hydrogenated dimer acid, trimmer acid, hydrogenated trimmer acid, chlorendic acid, chlorendic anhydride, methyl pentachloro octadecanoate, or a combination of two or more thereof may be used. In general, an organic acid having a too long carbon chain causes lowering of solubility in an alcohol solvent, while an organic acid having a too short carbon chain causes lowering of the softening point of the flux. From the viewpoint of the solubility in an alcohol solvent and the softening point of the flux, suberic acid, sebacic acid or a combination thereof is preferred as an organic acid having an appropriate length of carbon chain among the organic acids described above.

The flux may or may not contain an amine. The amine has an effect for lowering the softening point of the flux, so that the softening point of the flux can be adjusted by adjusting the content of amine in the flux.

The ratio of the content of the amine (mass%) to the content of the rosin-based resin (mass%) (Amine content (mass%)/Rosin-based resin content (mass%)) in the flux is not particularly limited, and preferably 0 or more and 0.15 or less, more preferably 0 or more and 0.015 or less, still more preferably more than 0 and 0.015 or less, and most preferably 0.01 to 0.015. With a ratio in the numerical value range, the softening point of the flux can be adjusted to an appropriate range.

The content of the amine (mass%) based on the whole flux is not particularly limited, and preferably 0 mass% or more and 4 mass% or less, more preferably more than 0 mass% and 1.5 mass% or less, and most preferably 0.2 to 1.2 mass%. With the content of the amine (mass%) in the numerical value range, the softening point of the flux can be adjusted to an appropriate range.

The amine is not particularly limited, and an aliphatic amine, an aromatic amine, an amino alcohol, imidazole, benzotriazole, an amino acid, guanidine, hydrazide or a combination of two or more thereof may be used.

As the aliphatic amine, dimethylamine, ethylamine, 1-aminopropane, isopropyl amine, trimethylamine, allylamine, n-butyl amine, diethylamine, sec-butylamine, tert-butylamine, N,N-dimethyl ethylamine, isobutylamine, triethylamine, cyclohexylamine, or a combination of two or more thereof may be used.

As the aromatic amine, aniline, N-methylaniline, diphenylamine, N-isopropyl aniline, p-isopropyl aniline, or a combination of two or more thereof may be used.

As the amino alcohol, 2-aminoethanol, 2-(ethylamino)ethanol, diethanol amine, monoisopropanol amine, diisopropanol amine, triethanol amine, N-butyl diethanol amine, triisopropanol amine, N,N-bis(2-hydroxyethyl)-N-cyclohexyl amine, N,N,N',N'-tetrakis(2-hydroxypropyl)ethylenediamine, N,N,N',N'',N''-pentakis(2-hydroxypropyl)diethylenetriamine, or a combination of two or more thereof may be used.

As the imidazole, 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1 -cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')] -ethyl-s-triazine, 2,4-diamino-6-[2'-methylimidazolyl-(1')] -ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 2-methylimidazoline, 2-phenylimidazoline, 2,4-diamino-6-vinyl-s-triazine, 2, 4-diamino-6-vinyl-s-triazine isocyanuric acid adduct, 2,4-diamino-6-methacryloyloxyethyl-s-triazine, epoxy-imidazole adduct, 2-methylbenzimidazole, 2-octylbenzimidazole, 2-pentylbenzimidazole, 2-(1-ethylpentyl)benzimidazole, 2-nonylbenzimidazole, 2-(4-thiazolyl)benzimidazole, benzimidazole, or a combination of two or more thereof may be used.

As the benzotriazole, 2-(2'-hydroxy-5'-methylphenyl)benzotriazole, 2-(2'-hydroxy-3',5'-di-tert-amylphenyl)benzotriazole, 2-(2'-hydroxy-5 '-tert-octylphenyl)benzotriazole, 2,2'-methylenebis[6-(2H-benzotriazol-2-yl)-4-tert-octylphenol], 6-(2-benzotriazolyl)-4-tert-octyl-6'-tert-butyl-4'-methyl-2,2'-methylenebisphenol, 1,2,3-benzotriazole, 1-[N,N-bis(2-ethylhexyl)amino methyl]benzotriazole, carboxy benzotriazole, 1-[N,N-bis(2-ethylhexyl)amino methyl]methyl benzotriazole, 2,2'-[[(methyl-1H-benzotriazole-1-yl)methyl]imino]bis ethanol, 1,2,3-benzotriazole sodium salt aqueous solution, 1-(1',2'-dicarboxyethyl)benzotriazole, 1-(2,3-dicarboxypropyl)benzotriazole, 1-[(2-ethylhexylamino)methyl]benzotriazole, 2,6-bis[(1H-benzotriazol-1-yl)methyl]-4-methylphenol, 5-methylbenzotriazole, or a combination of two or more thereof may be used.

As the amino acid, alanine, arginine, asparagine, aspartic acid, glutamine, glutamic acid, glycine, histidine, isoleucine, leucine, methionine, phenylalanine, proline, serine, threonine, tryptophan, tyrosine, valine, β-alanine, γ-aminobutyric acid, δ-aminovaleric acid, ε-aminohexanoic acid, ε-caprolactam, 7-aminoheptanoic acid, or a combination of two or more thereof may be used.

As the guanidine, dicyandiamide, 1,3-diphenylguanidine, 1,3-di-o-tolylguanidine, or a combination of two or more thereof may be used.

As the hydrazide, carbonic dihydrazide, malonic acid dihydrazide, succinic acid dihydrazide, adipic acid dihydrazide, 1,3-bis(hydrazinocarbonoethyl)-5-isopropylhydantoin, sebacic acid dihydrazide, dodecanedioic acid dihydrazide, 7,11-octadecadien-1,18-dicarbohydrazide, isophthalic acid dihydrazide, or a combination of two or more thereof may be used.

Among these amines, from the viewpoints of the solubility in an alcohol solvent, improvement in solder wettability, and compatibility with a rosin-based resin after formation of a flux coating layer, monoisopropanol amine, 2-methylimidazole, triethylamine, or a combination of two or more thereof is preferred.

The flux may further contain an amine hydrohalide. As the amine hydrohalide, a hydrohalide (such as a salt of HBr, HCl, HF or HI) may be used.

In the flux, the ratio of the content of the amine hydrohalide (mass%) to the content of the rosin-based resin (mass%) (Amine hydrohalide content (mass%)/Rosin-based resin content (mass%)) is not particularly limited, and preferably 0 or more and 0.2 or less, more preferably more than 0 and 0.05 or less, and most preferably 0.03 to 0.04. With a ratio in the numerical value range, the flux is sufficiently activated.

In the case where a flux contains an amine hydrobromide and an organic bromine compound to be described later and contains no organic acid and no amine, in order to adjust the softening point of the flux to an appropriate range, the ratio (Amine hydrobromide content (mass%)/Rosin-based resin content (mass%)) is preferably 0.001 to 0.01, and the ratio (Organic bromine compound content (mass%)/Rosin-based resin content (mass%)) is preferably 0.01 to 0.03. In the case where a flux contains an amine hydrobromide and contains no organic acid, no amine and no organic bromine compound to be described later, in order to adjust the softening point of the flux to an appropriate range, the ratio (Amine hydrobromide content (mass%)/Rosin-based resin content (mass%)) is preferably 0.03 to 0.05. In the case where a flux contains an organic acid and an amine hydrobromide and contains no amine and no organic bromine compound to be described later, in order to adjust the softening point of the flux to an appropriate range, the ratio (Organic acid content (mass%)/Rosin-based resin content (mass%)) is preferably 0.001 to 0.15, and the ratio (Amine hydrobromide content (mass%)/Rosin-based resin content (mass%)) is preferably 0.001 to 0.05. In the case where a flux contains an amine and an amine hydrobromide and contains no organic acid and no organic bromine compound to be described later, in order to adjust the softening point of the flux to an appropriate range, the ratio (Amine content (mass%)/Rosin-based resin content (mass%)) is preferably 0.001 to 0.015, and the ratio (Amine hydrobromide content (mass%)/Rosin-based resin content (mass%)) is preferably 0.001 to 0.05.

The content of the amine hydrohalide (mass%) based on the whole flux is not particularly limited, and preferably 0 mass% or more and 9 mass% or less, more preferably 0 mass% or more and 4 mass% or less, still more preferably more than 0 mass% and 4 mass% or less, and most preferably 0.1 to 3.5 mass%. With the content of the amine hydrohalide (mass%) in the numerical value range, the flux is sufficiently activated.

The amine hydrohalide is not particularly limited, and 2-ethylhexylamine hydrobromide, pyridine hydrobromide, isopropylamine hydrobromide, cyclohexylamine hydrobromide, monoethylamine hydrobromide, diethylamine hydrobromide, triethylamine hydrobromide, 1,3-diphenylguanidine hydrobromide, dimethylamine hydrobromide, rosin amine hydrobromide, 2-pipecoline hydrobromide, hydrazine hydrate hydrobromide, trinonylamine hydrobromide, diethylaniline hydrobromide, 2-diethylaminoethanol hydrobromide, diallylamine hydrobromide, hydrazine monohydrobromide, hydrazine dihydrobromide, aniline hydrobromide, dimethylcyclohexylamine hydrobromide, ethylenediamine dihydrobromide, 2-phenylimidazole hydrobromide, 4-benzylpyridine hydrobromide, stearylamine hydrochloride, diethylaniline hydrochloride, diethanolamine hydrochloride, dimethylamine hydrochloride, 2-ethylhexylamine hydrochloride, isopropylamine hydrochloride, cyclohexylamine hydrochloride, 1,3-diphenyl guanidine hydrochloride, dimethylbenzylamine hydrochloride, dimethylcyclohexylamine hydrochloride, 2-diethylaminoethanol hydrochloride, diallylamine hydrochloride, monoethylamine hydrochloride, diethylamine hydrochloride, triethylamine hydrochloride, hydrazine monohydrochloride, hydrazine dihydrochloride, pyridine hydrochloride, butylamine hydrochloride, hexylamine hydrochloride, n-octylamine hydrochloride, dodecylamine hydrochloride, L-glutamic hydrochloride, N-methylmorpholine hydrochloride, betaine hydrochloride, ammonium chloride, 2-pipecoline hydroiodide, cyclohexylamine hydroiodide, 1,3-diphenylguanidine hydrofluoride, diethylamine hydrofluoride, 2-ethylhexylamine hydrofluoride, cyclohexylamine hydrofluoride, ethylamine hydrofluoride, rosin amine hydrofluoride, cyclohexylamine tetrafluoroborate, dicyclohexylamine tetrafluoroborate, or a combination of two or more thereof may be used. Among these, from the viewpoint of solubility in an alcohol solvent and improvement in wettability of solder, an amine hydrobromide, in particular, 1,3-diphenylguanidine hydrobromide, monoethylamine hydrobromide, diethylamine hydrobromide, cyclohexylamine hydrobromide, or a combination of two or more thereof is preferred.

The flux may or may not contain an organic bromine compound.

In the flux, the ratio of the content of the organic bromine compound (mass%) to the content of the rosin-based resin (mass%) (Organic bromine compound content (mass%)/Rosin-based resin content (mass%)) is not particularly limited, and preferably 0 or more and 0.12 or less, more preferably more than 0 and 0.05 or less, and most preferably 0.01 to 0.02. With a ratio in the numerical value range, the flux is sufficiently activated.

The content of the organic bromine compound (mass%) based on the whole flux is not particularly limited, being preferably 0 mass% or more and 5 mass% or less, more preferably more than 0 mass% and 3 mass% or less, and preferably 0.5 to 2 mass%. With the content of the organic bromine compound (mass%) in the numerical value range, the flux is sufficiently activated.

The organic bromine compound is not particularly limited, and trans-2,3-dibromo-2-butene-1,4-diol, 2,3-dibromo-1,4-butanediol, 2,3-dibromo-1-propanol, 1,1,2,2-tetrabromoethane, 2,2,2-tribromoethanol, pentabromoethane, carbon tetrabromide, 2,2-bis(bromomethyl)-1,3-propanediol, meso-2,3-dibromosuccinic acid, n-hexadecyltrimethylammonium bromide, triallyl isocyanurate hexabromide, 2,2-bis[3,5-dibromo-4-(2,3-dibromopropoxy)phenyl]propane, bis[3,5-dibromo-4-(2,3-dibromopropoxy)phenyl]sulfone, ethylene bis(pentabromobenzene), brominated bisphenol A-type epoxy resin, or a combination of two or more of these may be used. Among these, from the viewpoints of solubility in an alcohol solvent and improvement in wettability of solder, trans-2,3-dibromo-2-butene-1,4-diol, 2,3-dibromo-1,4-butanediol, or a combination thereof is preferred.

The flux may contain a solvent.

The content of the solvent (mass%) based on the whole flux is not particularly limited, and may be 10 to 90 mass%, 20 to 80 mass%, or 30 to 70 mass%. With the content of the solvent (mass%) in the ranges of the numerical values, the other components are completely dissolved in the solvent, so that a uniform coating of flux is achieved.

The solvent is not particularly limited, and examples thereof include water, an alcohol-based solvent, a glycol ether-based solvent, and terpineols. Examples of the alcohol-based solvent include isopropyl alcohol, 1,2-butanediol, isobornyl cyclohexanol, 2,4-diethyl-1,5-pentanediol, 2,2-dimethyl-1,3-propanediol, 2,5-dimethyl-2,5-hexanediol, 2,5-dimethyl-3-hexyne-2,5-diol, 2,3-dimethyl-2,3-butanediol, 1,1,1-tris(hydroxymethyl)ethane, 2-ethyl-2-hydroxymethyl-1,3-propanediol, 2,2'-oxybis(methylene)bis(2-ethyl-1,3-propanediol), 2,2-bis(hydroxymethyl)-1,3-propanediol, 1,2,6-trihydroxyhexane, bis[2,2,2-tris(hydroxymethyl)ethyl]ether, 1-ethynyl-1-cyclohexanol, 1,4-cyclohexanediol, 1,4-cyclohexane dimethanol, erythritol, threitol, guaiacol glycerol ether, 3,6-dimethyl-4-octyne-3,6-diol, and 2,4,7,9-tetramethyl-5-decyne-4,7-diol. Examples of the glycol ether-based solvent include diethylene glycol mono-2-ethylhexyl ether, ethylene glycol monophenyl ether, 2-methylpentane-2,4-diol, diethylene glycol monohexyl ether, diethylene glycol dibutyl ether, and triethylene glycol monobutyl ether. One or a combination of two or more of these solvents may be used. In particular, isopropyl alcohol is preferred from the viewpoints of the solubility of a rosin-based resin and an activator, and the low toxicity.

The flux may or may not contain a resin other than the rosin-based resin. In the case where resins other than the rosin-based resin are contained as impurities in the flux, though not intentionally added to the flux, the content of the other resins based on the whole flux is preferably 0.1 mass% or less, more preferably 0.01 mass% or less.

The resins other than the rosin-based resin are not particularly limited, and an acrylic resin, a terpene resin, a modified terpene resin, a terpene phenol resin, a modified terpene phenol resin, a styrene resin, a modified styrene resin, a xylene resin, a modified xylene resin, or a combination of two or more thereof may be used. As the modified terpene resin, an aromatic modified terpene resin, a hydrogenated terpene resin, a hydrogenated aromatic modified terpene resin, or a combination of two or more thereof may be used. As the modified terpene phenol resin, a hydrogenated terpene phenol resin may be used. As the modified styrene resin, a styrene acrylic resin, a styrene maleic acid resin, or a combination of two or more thereof may be used. As the modified xylene resin, a phenol-modified xylene resin, an alkylphenol-modified xylene resin, a phenol-modified resol-type xylene resin, a polyol-modified xylene resin, a polyoxyethylene-added xylene resin, or a combination of two or more thereof may be used.

The flux may not contain an activator other than the aforementioned organic acid, amine, amine hydrohalide, and organic bromine compound, or may further contain the activator. Such an activator is not particularly limited, and an organic halogen compound may be used.

As the organic halogen compound, an organic halogen compound other than the aforementioned organic bromine compounds may be used. The organic halogen compound other than the organic bromine compounds is not particularly limited, and chlorendic acid, chlorendic anhydride, methyl pentachloro octadecanoate, 2,3-dichloro-1-propanol, or a combination of two or more thereof may be used.

The flux may further contain a colorant, a surfactant, or a combination thereof.

[Flux-coated solder preform]

The flux-coated solder preform of the present invention includes a solder preform, and a flux coating layer present on the surface of the solder preform, wherein the flux coating layer is formed from the flux. The flux-coated solder preform of the present invention includes a flux coating layer having a softening point of 80 to 120°C, or a flux coating layer having a tack strength of 0.98 N (100 gf) or more measured under conditions of 130°C, and a tack strength of 0.98 N (100 gf) or less measured under conditions of 80°C.

Fig. 1 is a perspective view showing a flux-coated solder preform 10 in an embodiment of the present invention. In the embodiment shown in Fig. 1, a flux coating layer 30 is formed on each of the upper face and lower face (bottom face) of a solder preform 20.

The metal constituting the solder preform is not particularly limited, and examples thereof include Sn-Ag system, Sn-Cu system, Sn-Sb system, Sn-Ag-Cu system, Sn-Ag-Cu-Sb system, Sn-Ag-Cu-In system, Sn-Ag-Cu-Bi system, Sn-Ag-Cu-Bi-Sb system, Sn-Pb system, Sn-Bi system, and Sn-In system. In particular, Sn-Ag-Cu system and Sn-Ag-Cu-Sb system are preferred. Specifically, a solder composition of Sn-3Ag-0.5Cu (Ag: 3 mass%, Cu: 0.5 mass%, Sn: balance) is preferred.

The shape of the solder preform is not particularly limited, and examples thereof include a ribbon (tape or long and thin band), a square (hexahedron with square upper and lower surfaces, with a small thickness, example of thickness: 0.05 to 2.5 mm), a disk, a washer, a chip (hexahedron with square upper and lower faces, with a thickness larger than square, example of thickness: 0.3 to 1.6 mm), and a wire (metal wire, thin thread-like metal). It is preferable that the shape be matched to the land pattern.

The thickness of a solder preform is not particularly limited, preferably 50 to 500 μm, more preferably 100 to 400 μm, and most preferably 150 to 300 μm.

The softening point of the flux coating layer is 80 to 120°C. With a softening point of the flux coating layer in the numerical value range, the flux coating layer has an adhesiveness in an appropriate range, so that the workability in drawing out the flux-coated solder preform from a reel is improved and misalignment of electronic components during reflow soldering is suppressed. Regarding the softening point of the flux coating layer, the same numerical value and numerical value range as for the softening point of the flux described in the item of the flux for the flux-coated solder preform may be used. Regarding the measurement method and the measurement sample of the softening point of the flux coating layer, the same ones as for the softening point of the flux described in the item of the flux for the flux-coated solder preform may be used.

The tack strength of the flux coating layer measured under conditions of 130°C is preferably 0.98 N (100 gf) or more, more preferably 1.03 N (105 gf) or more, and most preferably 1.08 N (110 gf) or more. The tack strength of the flux coating layer measured under conditions of 80°C is preferably 0.98 N (100 gf) or less, more preferably 0.49 N (50 gf) or less, 0.29 N (30 gf) or less, 0.20 N (20 gf) or less, or 0.098 N (10 gf) or less, in this order. The tack strength of the flux coating layer measured under conditions of 120°C is not particularly limited, and preferably 0.98 N (100 gf) or more, more preferably 1.03 N (105 gf) or more, and most preferably 1.08 N (110 gf) or more.

With a tack strength of the flux coating layer measured under conditions of 130°C and a tack strength measured under conditions of 80°C in the numerical value ranges, the flux coating layer has an adhesiveness in an appropriate range, so that the workability in drawing out the flux-coated solder preform from a reel is improved and misalignment of electronic components during reflow soldering is suppressed. The tack strength of the flux coating layer may be measured by the method to be described in [Examples] described below.

The flux coating layer may be formed by applying a flux (in liquid state) to the surface of a solder preform, and then drying the applied flux layer to volatilize the solvent component. The flux before application to a solder preform contains components such as a rosin-based resin, an activator, and a solvent. The flux coating layer obtained by drying the flux contains all the components other than components to be lost due to volatilization by drying (solvent or the like) in the components contained in the flux. The solvent has a relatively low boiling point and easily volatilizes, and thus basically does not remain in the flux coating layer. However, depending on drying conditions, a part of the solvent may remain in the flux coating layer. The flux coating layer, therefore, may contain residual solvent other than the compositions.

The flux coating layer is not particularly limited, and may be formed on the upper face, the lower face (bottom face), or the side face of the solder preform, or on faces of two or more thereof. It is preferable that the flux coating layer be formed on both the upper face and the lower face.

The thickness of the flux coating layer is not particularly limited, and in the case where the layer is formed on both the upper face and the lower face, the total thickness at the upper face and the lower face is preferably 10 to 50 μm, more preferably 20 to 30 μm or 35 to 45 μm. In the case where the layer is formed on the upper face only, the lower face only, or both the upper face and the lower face, the thickness of the upper face or the lower face is preferably 5 to 25 μm, more preferably 10 to 15 μm or 17.5 to 22.5 μm.

The content of the flux coating layer based on the whole flux-coated solder preform is not particularly limited, and is preferably 0.1 to 12 mass%, more preferably 1 to 5 mass%, and most preferably 1 to 3 mass%.

It is preferable that the flux coating layer contain a hydrogenated acid-modified rosin and a hydrogenated rosin.

In the flux coating layer, the ratio of the content of the hydrogenated acid-modified rosin (mass%) to the content of the hydrogenated rosin (mass%) (Hydrogenated acid-modified rosin content (mass%)/Hydrogenated rosin content (mass%)) is not particularly limited, and the same numerical value and the numerical value range as the ratio for the flux described in the item of flux for flux-coated solder preform may be used. With a ratio less than the lower limit, the flux coating layer has a lowered softening point and a too large adhesiveness, so that the workability in drawing out the flux-coated solder preform from a reel is lowered. With a ratio more than the upper limit, the flux coating layer has an increased softening point and a too small adhesiveness, so that misalignment of electronic components during reflow soldering occurs.

The content of the hydrogenated acid-modified rosin (mass%) based on the whole flux coating layer is not particularly limited, and the lower limit thereof may be 15 mass% or more, 45 mass% or more, 50 mass% or more or 55 mass% or more. Further, the upper limit thereof may be 85.8 mass% or less, 80 mass% or less, 75 mass% or less or 70 mass% or less. The content of the hydrogenated acid-modified rosin (mass%) may be in the numerical value range in combination of any of the lower limit and any of the upper limit.

The content of the hydrogenated rosin (mass%) based on the whole flux coating layer is not particularly limited, and the lower limit thereof may be 2 mass% or more, 20 mass% or more, 25 mass% or more or 30 mass% or more. Further, the upper limit thereof may be 85 mass% or less, 50 mass% or less, 45 mass% or less or 40 mass% or less. The hydrogenated rosin content (mass%) may be in the numerical value range in combination of any of the lower limit and any of the upper limit.

With the content of the hydrogenated acid-modified rosin (mass%) and the content of the hydrogenated rosin (mass%) in the numerical value ranges, the softening point of the flux coating layer may be adjusted to an appropriate range.

The hydrogenated rosin and the hydrogenated acid-modified rosin are not particularly limited, and the compounds described in the item of flux for flux-coated solder preform may be used.

The content of rosin-based resin other than the hydrogenated acid-modified rosin and the hydrogenated rosin (mass%) based on the whole flux coating layer is not particularly limited, and may be 0 mass% (containing no rosin-based resin other than the hydrogenated acid-modified rosin and the hydrogenated rosin) in the same manner as the content in the flux described in the item of flux for flux-coated solder preform. In that case, the rosin-based resin contained in the flux coating layer is made of (consists of) hydrogenated acid-modified rosin and hydrogenated rosin.

The rosin-based resin other than hydrogenated acid-modified rosin and hydrogenated rosin is not particularly limited, and the compound described in the item of flux for flux-coated solder preform may be used.

The flux coating layer may or may not contain an organic acid. The organic acid has an effect for lowering the softening point of the flux coating layer, so that the organic acid content in the flux coating layer may be adjusted to adjust the softening point of the flux coating layer.

The ratio of the content of the organic acid (mass%) to the content of the rosin-based resin (mass%) (Organic acid content (mass%)/Rosin-based resin content (mass%)) in the flux coating layer is not particularly limited, and the same numerical value and the numerical value range as the ratio for the flux described in the item of flux for flux-coated solder preform may be used.

The content of the organic acid (mass%) based on the whole flux coating layer is not particularly limited, and preferably 0 mass% or more and 0.7 mass% or less. With the content of the organic acid (mass%) in the numerical value range, the softening point of the flux coating layer may be adjusted to an appropriate range.

The organic acid is not particularly limited, and the compounds described in the item of flux for flux-coated solder preform may be used. Based on the same reason described in the item of flux for flux-coated solder preform, from the viewpoints of the solubility in an alcohol solvent and the softening point of the flux coating layer, as the organic acid having a carbon chain with an appropriate length among the organic acids described above, suberic acid, sebacic acid, or a combination thereof is preferred.

The flux coating layer may or may not contain an amine. The amine has effect for lowering the softening point of the flux coating layer, so that the content of the amine in the flux coating layer may be adjusted to adjust the softening point of the flux coating layer.

The ratio of the content of the amine (mass%) to the content of the rosin-based resin (mass%) (Amine content (mass%)/Rosin-based resin content (mass%)) in the flux coating layer is not particularly limited, and the same numerical value and the numerical value range as the ratio described in the item of flux for flux-coated solder preform may be used. With a ratio in the numerical value range, the softening point of the flux coating layer may be adjusted to an appropriate range.

The content of the amine (mass%) based on the whole flux coating layer is not particularly limited, and preferably 0 mass% or more and 10 mass% or less, more preferably 0 mass% or more and 1.5 mass% or less, still more preferably more than 0 mass% and 1.5 mass% or less, and most preferably 0.8 to 1.2 mass%. With the content of the amine (mass%) in the numerical value range, the softening point of the flux coating layer may be adjusted to an appropriate range.

The amine is not particularly limited, and the compounds described in the item of flux for flux-coated solder preform may be used. Among these amines, from the viewpoints of the solubility in an alcohol solvent, the improvement in wettability of solder, and the compatibility with the rosin-based resin in the flux coating layer, monoisopropanol amine, 2-methylimidazole, triethylamine, or a combination of two or more thereof is preferred.

The flux coating layer may further contain an amine hydrohalide.

In the flux coating layer, the ratio of the content of the amine hydrohalide (mass%) to the content of the rosin-based resin (mass%) (Amine hydrohalide content (mass%)/Rosin-based resin content (mass%)) is not particularly limited, and the same numerical value and the numerical value range as the ratio for the flux described in the item of flux for flux-coated solder preform may be used. With a ratio in the numerical value range, the flux coating layer is sufficiently activated.

In the case where the flux coating layer contains an amine hydrobromide and an organic bromine compound to be described later and contains no organic acid and no amine, in order to adjust the softening point of the flux coating layer to an appropriate range, the ratio (Amine hydrobromide content (mass%)/Rosin-based resin content (mass%)) is preferably 0.001 to 0.01, and the ratio (Organic bromine compound content (mass%)/Rosin-based resin content (mass%)) is preferably 0.01 to 0.03. In the case where the flux coating layer contains an amine hydrobromide and contains no organic acid, no amine and no organic bromine compound to be described later, in order to adjust the softening point of the flux coating layer to an appropriate range, the ratio (Amine hydrobromide content (mass%)/Rosin-based resin content (mass%)) is preferably 0.03 to 0.05. In the case where the flux coating layer contains an organic acid and an amine hydrobromide and contains no amine and no organic bromine compound to be described later, in order to adjust the softening point of the flux coating layer to an appropriate range, the ratio (Organic acid content (mass%)/Rosin-based resin content (mass%)) is preferably 0.001 to 0.15, and the ratio (Amine hydrobromide content (mass%)/Rosin-based resin content (mass%)) is preferably 0.001 to 0.05. In the case where the flux coating layer contains an amine and an amine hydrobromide and contains no organic acid and no organic bromine compound to be described later, in order to adjust the softening point of the flux coating layer to an appropriate range, the ratio (Amine content (mass%)/Rosin-based resin content (mass%)) is preferably 0.001 to 0.015, and the ratio (Amine hydrobromide content (mass%)/Rosin-based resin content (mass%)) is preferably 0.001 to 0.05.

The content of the amine hydrohalide (mass%) based on the whole flux coating layer is not particularly limited, and preferably 0 mass% or more and 4 mass% or less, more preferably more than 0 mass% and 4 mass% or less, and preferably 0.4 to 3.5 mass%. With the content of the amine hydrohalide (mass%) in the numerical value range, the flux coating layer is sufficiently activated.

The amine hydrohalide is not particularly limited, and the compounds described in the item of flux for flux-coated solder preform may be used. Among them, from the viewpoints of the solubility in an alcohol solvent and the improvement in wettability of solder, an amine hydrobromide, in particular, 1,3-diphenylguanidine hydrobromide, monoethylamine hydrobromide, diethylamine hydrobromide, cyclohexylamine hydrobromide, or a combination of two or more thereof is preferred.

The flux coating layer may or may not contain an organic bromine compound.

In the flux coating layer, the ratio of the content of the organic bromine compound (mass%) to the content of the rosin-based resin (mass%) (Organic bromine compound content (mass%)/Rosin-based resin content (mass%)) is not particularly limited, and the same numerical value and the numerical value range as the ratio for the flux described in the item of flux for flux-coated solder preform may be used. With a ratio in the numerical value range, the flux coating layer is sufficiently activated.

The content of the organic bromine compound (mass%) based on the whole flux coating layer is not particularly limited, and preferably 0 mass% or more and 10 mass% or less, more preferably more than 0 mass% and 4 mass% or less, and most preferably 1 to 2 mass%. With the content of the organic bromine compound (mass%) in the numerical value range, the flux coating layer is sufficiently activated.

The organic bromine compound is not particularly limited, and the compounds described in the item of flux for flux-coated solder preform may be used. Among them, from the viewpoints of the solubility in an alcohol solvent and the improvement in wettability of solder, trans-2,3-dibromo-2-butene-1,4-diol, 2,3-dibromo-1,4-butane diol, or a combination thereof is preferred.

The flux coating layer may or may not contain a resin other than the rosin-based resin. In the case where a resin other than the rosin-based resin is not intentionally added to the flux coating layer and may be contained as impurities, the other resin content based on the whole flux coating layer is preferably 0.1 mass% or less, more preferably 0.01 mass% or less.

The resin other than the rosin-based resin is not particularly limited, and the compounds described in the item of flux for flux-coated solder preform may be used.

The flux coating layer may not contain an activator other than the aforementioned organic acid, amine, amine hydrohalide, and organic bromine compound, or may further contain the activator. Such an activator is not particularly limited, and the compounds described in the item of flux for flux-coated solder preform may be used.

The flux coating layer may further contain a colorant, a surfactant, or a combination thereof.

[Method for mounting electronic component on electronic substrate]

The method for mounting electronic components on an electronic substrate of the present invention includes a step of disposing the flux-coated solder preform on the electronic substrate and disposing the electronic components on the flux-coated solder preform so as to form a laminate including the electronic substrate, the flux-coated solder preform and the electronic component, and a step of heating the laminate to melt the flux coating layer and the solder preform and then cooling the laminate to solidify the solder preform for bonding the electronic substrate to the electronic components.

(Embodiment of method for mounting electronic component on electronic substrate)

Fig. 2 is a schematic view showing a procedure for producing a substrate for a communication base station, which is in an embodiment of the method for mounting electronic components on an electronic substrate of the present invention. First, a laminate of a printed circuit board 40 and a heat sink 50 is prepared. The laminate is provided with a recessed part, in which a flux-coated solder preform 10 shown in Fig. 1 (having a flux coating layer on each of the upper face and the lower face) is disposed. On the flux-coated solder preform 10 of the resulting laminate (including the printed circuit board 40, the heat sink 50, and the flux-coated solder preform 10), an electronic component (signal amplification device) 60 is disposed. The resulting laminate (including the printed circuit board 40, the heat sink 50, the flux-coated solder preform 10 and the electronic component 60) is heated to melt the flux coating layer and the solder preform of the flux-coated solder preform 10. The laminate is then cooled to solidify the solder preform, so that the electronic component (signal amplification device) 60 and the laminate are bonded.

The electronic substrate to which the mounting method of the present invention is applied is not particularly limited, and examples thereof include a highly heat-resistant glass fiber reinforced epoxy-based printed circuit board and a polyimide-based substrate having a heat resistance grade of FR4, and a ceramic substrate. A metal plating may be applied to the land of an electronic substrate. Examples of the metal for use in the metal plating include gold, silver, nickel and tin.

The electronic component to which the mounting method of the present invention is applied is not particularly limited, and use of a signal amplification device or PCB (printed wiring board) is preferred.

The temperature at which the laminate including the electronic substrate, the flux-coated solder preform, and the electronic component is heated to melt the flux-coated solder preform is different depending on the composition of the solder preform. The temperature at a melting point of solder alloy plus 20 to 50°C is usually preferred, and the temperature at a melting point of solder alloy plus 20 to 30°C is more preferred. The heating time for melting the flux-coated solder preform is preferably 20 to 60 seconds, more preferably 30 to 60 seconds, and most preferably 30 to 45 seconds.

In the method for mounting an electronic component on an electronic substrate of the present invention, it is preferable to perform reflow soldering.

Hereinafter, the present invention is more specifically described with reference to Examples, though the present invention is not limited thereto.

EXAMPLES

(Examples 1 to 22, and Comparative Examples 1 to 4)

Using the compositions shown in the following Tables 2 and 4, fluxes in Examples 1 to 22 and Comparative Examples 1 to 4 were prepared, respectively.

The numerical value of each component shown in Tables 2 and 4 represents the content (mass%) of each component based on the whole flux, and the description of Component A (mass%)/Component B (mass%) represents the ratio (proportion) of the content of the component A (mass%) to the content of the component B (mass%) in the flux.

In the case where the flux is applied to the surface of a solder preform and dried at about 100°C to form a flux coating layer, it is presumed that only a solvent with a relatively low boiling point contained in the flux volatilizes and other components remain in the flux coating layer. Considering this point, calculation of content (mass%) of each component based on the whole flux coating layer (total of components other than solvent) using the numerical values of each component in Tables 2 and 4 results in the numerical value of each component in "Flux coating layer" in Tables 3 and 5.

Incidentally, as described above, it can be presumed that there exists no change in the component between the flux and the flux coating layer except that the solvent volatizes. As a result, it can be presumed that the ratio of Component A (mass%)/Component B (mass%) in "flux" shown in Tables 2 and 4 is the ratio of Component A (mass%)/Component B (mass%) in flux coating layer.

Each of the fluxes thus prepared in Examples 1 to 22 and Comparative Examples 1 to 4 in an amount of 100 ml was placed in a 100-ml graduated cylinder. A plate was fixed to the drive part of Elecylinder (registered trademark) EC-S6S-150-2-B (manufactured by IAI Corporation), and to the tip of the plate, an end of a solder preform (ECO SOLDER RIBBON S M705, manufactured by Senju Metal Industry Co., Ltd., Composition: SAC305 (SnAg3Cu0.5), shape: ribbon, width: 25 mm, length: 200 mm, thickness: 0.25 mm) was fixed with a tape. Above the graduated cylinder containing the flux, the Elecylinder (registered trademark) was driven to immerse a part of the solder preform (length: 150 mm) into the flux, which was left standing still for 1 second. Then the Elecylinder (registered trademark) was driven to pull the solder preform out from the flux, and the solder preform was dried in a thermostatic chamber at 100°C for 2 minutes to volatize the solvent, so that a flux coating layer was formed. Regarding a part that a flux coating layer is formed in the solder preform after drying, a 20 mm portion was cut off from each end of the part to obtain a central portion with a length of 110 mm, which was used as a sample of flux-coated solder preform.

The content of the flux coating layer (mass%) based on the whole flux-coated solder preform (Mx) may be calculated using a sample of flux-coated solder preform obtained in the same manner as described above. Specifically, the mass of the sample of flux-coated solder preform (Ma) was measured. The sample was then washed with isopropyl alcohol to completely remove the portion of the flux coating layer, and dried. After drying, the mass of the solder preform portion alone (Mb) was measured, and the Mx was calculated based on the following formula. The samples of flux-coated solder preform in Examples 1 to 22 and Comparative Examples 1 to 4 obtained by the procedure described above had Mx of about 2 mass%.

[Formula 1]

$$Mx = (Ma - Mb)/Ma \times 100$$

The solid content of flux (total of components other than solvent) in each of Examples 1 to 22 and Comparative Examples 1 to 4 was prepared to obtain each composition shown in the columns of "Flux coating layer" in Tables 3 and 5. The softening point of the flux (softening point of the flux coating layer in flux-coated solder preform) was then measured. The specific procedure is as follows.

First, a rosin-based resin alone was placed in a plate made of aluminum, and the plate was heated with a hot plate set at a temperature of 250°C. After confirming that the rosin-based resin was completely liquefied and the whole was uniformly mixed in the plate on the hot plate, components other than the rosin-based resin were added into the plate. After confirming that all the components in the plate on the hot plate were uniformly dissolved, the plate was taken out from the hot plate to be cooled, so that a solid content of the flux was obtained. The softening point of the resulting solid content of the flux was measured in accordance with the standard JIS K 5902-1969, and the resulting softening point of the flux was presumed as the softening point of the flux coating layer in the flux-coated solder preform. The measurement results of the softening point of the flux or the flux coating layer are shown in Tables 2 to 5.

(Evaluation)

Using each of the flux-coated solder preforms in Examples 1 to 22 and Comparative Examples 1 to 4, the following (1) Evaluation of tack strength, and (2) Evaluation of misalignment were performed. The results of the (1) and (2) are shown in Tables 2 to 5.

(1) Evaluation of tack strength

[Test conditions]

(Tack test)

The tack strength of the flux-coated solder preform was measured by the following method. Although the following measurement method is based on "JISZ 3284-3:2014 4.5 Adhesiveness test", a part of the measurement conditions was changed.

A flux-coated solder preform was placed on a stage of a tackiness tester TK-1 (manufactured by Malcom Co., Ltd.). The stage was heated, and the stage temperature was stabilized at 80°C, 120°C, or 130°C through control. The stage temperature was measured with a thermocouple. Subsequently, the probe of the tackiness tester (made of stainless steel, cylindrical shape having a diameter of 5.0 mm and an area of 19.6 $mm^2$) was lowered at a rate of 2.0 mm/s, so that the flux coating layer in the flux-coated solder preform was pressurized with the probe at a constant pressure of 3.92 N (400 gf). After application of the pressure, the probe was pulled out from the flux coating layer at 10 mm/s within 10 seconds to measure the maximum strength required for the peeling. The resulting measurement value was presumed as the tack strength (gf) at 80°C, 120°C, or 130°C.

With a tack strength at 80°C of 0.98 N (100 gf) or less, when the flux-coated solder preform in a ribbon shape is wound on a reel for storage, the neighboring flux coating layers contacted with each other do not stick to each other. As a result, workability in drawing out the flux-coated solder preform from the reel is good. On the other hand, with a tack strength at 80°C of more than 0.98 N (100 gf), the neighboring flux coating layers contacted with each other in a reel stick to each other, so that the workability described above is poor.

Further, with a tack strength at 130°C of 0.98 N (100 gf) or more, the retainability of the electronic component during reflow soldering is improved, so that misalignment of electronic component is unlikely to occur. On the other hand, with a tack strength at 130°C of less than 0.98 N (100 gf), the retainability of the electronic component during reflow soldering is lowered, so that misalignment of electronic component easily occurs.

(2) Evaluation of misalignment

A printed circuit board 40 (glass epoxy substrate with a length 105 mm, a width of 105 mm, and a thickness of 1.5 mm; terminals: 1 mm by 0.2 mm, with a pitch of 0.4 mm, 16 pieces per side, total 64 pieces/1 pc of QFN; Surface: Cu-OSP) and a QFN (Quad Flat Non-leaded package) 61 having a terminal electrode 611 and a lower face electrode 612 (a length of 8 mm, a width of 8 mm, and a thickness of 1.5 mm; lower face electrode: a length of 5 mm, and a width of 5 mm; terminals: a length of 1mm, a width of 0.2mm, with a pitch of 0.4 mm, 16 pcs per side, total 64 pcs/1 pc of QFN; surface: Cu-(electrolytic)Sn plating) were prepared. A schematic diagram of the QFN 61 viewed from the lower face side (printed circuit board side) is shown in Fig. 3, and a schematic diagram of the printed circuit board 40 viewed from the upper face side (electronic component side) is shown in Fig. 4. As shown in Fig. 4, a flux-coated solder preform 10 was mounted on the central portion of the printed circuit board 40 corresponding to the lower face electrode 612 of QFN 61. The QFN 61 was laminated on the printed circuit board 40, such that the resulting portion mounted with the flux-coated solder preform 10 of the printed circuit board 40 corresponded to the lower face electrode 612 of QFN 61. The sample for evaluating misalignment was thus obtained. The schematic view of the resulting sample is shown in Fig. 5.

The resulting sample was subjected to reflow soldering under a temperature profile shown in Fig. 6 (heating rate at 40 to 150°C: 1.1°C/s, preheating time at 150 to 180°C: 90 seconds, melting time of solder at 220°C or more: 75 seconds, peak temperature: 240°C) with a reflow furnace (SNR-850B, manufactured by Senju Metal Industry Co., Ltd.), so that the printed circuit board 40 and the QFN 61 were bonded. Each of the samples after reflow soldering was X-ray photographed to check the soldering state. For each of Examples 1 to 22 and Comparative Examples 1 to 4, 10 pieces each of the samples were prepared for X-ray photography. Each of the X-ray photographs of 10 samples was visually observed to check occurrence of misalignment between the portion of the printed circuit board 40 corresponding to the lower face electrode (portion with the solder preform 10 mounted) and the lower face electrode 612 of the QFN 61. The evaluation of misalignment was performed based on the criteria in the following Table 1. Examples of the X-ray photographs in evaluation of misalignment are shown in Fig. 7. The upper photograph in Fig. 7 shows an acceptable example, and the lower photograph shows an unacceptable example.

[Table 1]

Table 1

| Evaluation of misalignment | Criteria |
|---|---|
| Good (acceptable) | No misalignment was observed in all of the 10 samples. |
| Poor (unacceptable) | Misalignment was observed in one or more of the samples. |

[Table 2]

Table 2

| | | | Example | | | | | | | | | | | | |
|---|---|---|---|---|---|---|---|---|---|---|---|---|---|---|---|
| | | | 1 | 2 | 3 | 4 | 5 | 6 | 7 | 8 | 9 | 10 | 11 | 12 | 13 |
| Flux | Solvent | Isopropyl alcohol | 53.0 | 54.5 | 54.2 | 54.1 | 55.0 | 54.5 | 54.5 | 54.5 | 54.5 | 48.0 | 53.0 | 48.8 | 50.5 |
| | Rosin-based resin | Hydrogenated acrylic acid-modified rosin | 28.0 | 30.0 | 30.0 | 30.0 | 8.7 | 30.0 | 30.0 | 30.0 | 30.0 | 30.0 | 28.0 | 28.0 | 30.0 |
| | | Hydrogenated rosin | 18.0 | 14.0 | 14.0 | 14.0 | 34.8 | 14.0 | 14.0 | 14.0 | 14.0 | 14.0 | 18.0 | 18.0 | 14.0 |
| | | Polymerized rosin | | | | | | | | | | | | | |
| | Organic acid | Suberic acid | | | 0.3 | | | | | | | | | | |
| | | Adipic acid | | | | | | | | | | | | | |
| | | Sebacic acid | | | | | | | | | | | | | |
| | | Glutaric acid | | | | | | | | | | | | | |
| | | Diglycolic acid | | | | | | | | | | | | | |
| | Amine | Monoisopropanol amine | | | | 0.4 | | | | | | | | | |
| | | 2-Methyl imidazole | | | | | | | | | | | | | 4.0 |
| | | Triethylamine | | | | | | | | | | | | | |
| | Amine hydrohalide | 1,3-Diphenylguanizine hydrobromide | 0.2 | 1.5 | 1.5 | 1.5 | 1.5 | | | | | 8.0 | 0.2 | 0.2 | 1.5 |
| | | Monoethylamine hydrobromide | | | | | | 1.5 | | | | | | | |
| | | Diethylamine hydrobromide | | | | | | | 1.5 | | | | | | |
| | | Cyclohexylamine hydrobromide | | | | | | | | 1.5 | | | | | |
| | | Monoethylamine hydrochloride | | | | | | | | | 1.5 | | | | |
| | Organic bromine compound | trans-2,3-Dibromo-2-butene-1,4-diol | 0.8 | | | | | | | | | | | | |
| | | 2,3-Dibromo-1,4-butane diol | | | | | | | | | | | 0.8 | 5.0 | |
| | Total | | 100.0 | 100.0 | 100.0 | 100.0 | 100.0 | 100.0 | 100.0 | 100.0 | 100.0 | 100.0 | 100.0 | 100.0 | 100.0 |
| | Hydrogenated acid-modified rosin (mass%)/Hydrogenated rosin (mass%) | | 1.6 | 2.1 | 2.1 | 2.1 | 0.3 | 2.1 | 2.1 | 2.1 | 2.1 | 2.1 | 1.6 | 1.6 | 2.1 |
| | Organic acid (mass%)/Rosin-based resin (mass%) | | – | – | 0.01 | – | – | – | – | – | – | – | – | – | – |
| | Amine (mass%)/Rosin-based resin (mass%) | | – | – | – | 0.009 | – | – | – | – | – | – | – | – | 0.091 |
| | Amine hydrohalide (mass%)/Rosin-based resin (mass%) | | 0.004 | 0.034 | 0.034 | 0.034 | 0.034 | 0.034 | 0.034 | 0.034 | 0.034 | 0.182 | 0.004 | 0.004 | 0.034 |
| | Organic bromine compound (mass%)/Rosin-based resin (mass%) | | 0.017 | – | – | – | – | – | – | – | – | – | 0.017 | 0.109 | – |
| | Softening point of flux (°C) | | 102.9 | 110.6 | 112.2 | 96.7 | 80.2 | 116.2 | 113.8 | 113.4 | 108.8 | 112.0 | 111.4 | 91.0 | 102.0 |

[Table 3]

Table 3

| | | | | Example 1 | 2 | 3 | 4 | 5 | 6 | 7 | 8 | 9 | 10 | 11 | 12 | 13 |
|---|---|---|---|---|---|---|---|---|---|---|---|---|---|---|---|---|
| Flux coating layer | Rosin-based resin | Hydrogenated acrylic acid-modified rosin | | 59.6% | 65.9% | 65.5% | 65.4% | 19.4% | 65.9% | 65.9% | 65.9% | 65.9% | 57.7% | 59.6% | 54.7% | 60.6% |
| | | Hydrogenated rosin | | 38.3% | 30.8% | 30.6% | 30.5% | 77.4% | 30.8% | 30.8% | 30.8% | 30.8% | 26.9% | 38.3% | 35.2% | 28.3% |
| | | Polymerized rosin | | | | | | | | | | | | | | |
| | Organic acid | Suberic acid | | | | 0.7% | | | | | | | | | | |
| | | Adipic acid | | | | | | | | | | | | | | |
| | | Sebacic acid | | | | | | | | | | | | | | |
| | | Glutaric acid | | | | | | | | | | | | | | |
| | | Diglycolic acid | | | | | | | | | | | | | | |
| | Amine | Monoisopropanol amine | | | | | 0.9% | | | | | | | | | |
| | | 2-Methyl imidazole | | | | | | | | | | | | | | 8.1% |
| | | Triethylamine | | | | | | | | | | | | | | |
| | Amine hydrohalide | 1,3-Diphenylguanizine hydrobromide | | 0.4% | 3.3% | 3.3% | 3.3% | 3.3% | | | | | 15.4% | 0.4% | 0.4% | 3.0% |
| | | Monoethylamine hydrobromide | | | | | | | 3.3% | | | | | | | |
| | | Diethylamine hydrobromide | | | | | | | | 3.3% | | | | | | |
| | | Cyclohexylamine hydrobromide | | | | | | | | | 3.3% | | | | | |
| | | Monoethylamine hydrochloride | | | | | | | | | | 3.3% | | | | |
| | Organic bromine compound | trans-2,3-Dibromo-2-butene-1,4-diol | | 1.7% | | | | | | | | | | | | |
| | | 2,3-Dibromo-1,4-butane diol | | | | | | | | | | | | 1.7% | 9.8% | |
| | Total | | | 100.0% | 100.0% | 100.0% | 100.0% | 100.0% | 100.0% | 100.0% | 100.0% | 100.0% | 100.0% | 100.0% | 100.0% | 100.0% |
| | Softening point of flux coating layer (°C) | | | 102.9 | 110.6 | 112.2 | 96.7 | 80.2 | 116.2 | 113.8 | 113.4 | 108.8 | 112.0 | 111.4 | 91.0 | 102.0 |
| Evaluation | Tack strength (gf) | | 80°C | 3.1 | 2.8 | 5.0 | 9.2 | 41.3 | 5.6 | 3.8 | 8.5 | 7.5 | 22.4 | 18.4 | 74.4 | 17.6 |
| | | | 120°C | 110.6 | 114.5 | 175.0 | 116.8 | 70.2 | 48.1 | 91.1 | 137.9 | 137.3 | 126.6 | 308.3 | 245.3 | 290.2 |
| | | | 130°C | 225.0 | 170.6 | 177.8 | 192.6 | 130.4 | 140.7 | 118.4 | 179.7 | 147.7 | 304.0 | 280.6 | 253.8 | 217.0 |
| | Misalignment | | | Good | Good | Good | Good | Good | Good | Good | Good | Good | Good | Good | Good | Good |

[Table 4]

Table 4

| | | | Example | | | | | | | | | Comparative Example | | | |
|---|---|---|---|---|---|---|---|---|---|---|---|---|---|---|---|
| | | | 14 | 15 | 16 | 17 | 18 | 19 | 20 | 21 | 22 | 1 | 2 | 3 | 4 |
| Flux | Solvent | Isopropyl alcohol | 59.6 | 59.6 | 58.1 | 58.1 | 58.1 | 58.1 | 58.1 | 58.1 | 58.1 | 54.5 | 54.5 | 54.5 | 55.0 |
| | Rosin-based resin | Hydrogenated acrylic acid-modified rosin | 25.0 | 25.0 | 25.0 | 25.0 | 25.0 | 25.0 | 27.8 | 30.8 | 35.9 | | 44.0 | | 2.2 |
| | | Hydrogenated rosin | 12.0 | 12.0 | 12.0 | 12.0 | 12.0 | 12.0 | 9.3 | 6.2 | 1.1 | 44.0 | | | 41.3 |
| | | Polymerized rosin | | | | | | | | | | | | 44.0 | |
| | Organic acid | Suberic acid | 3.0 | | 3.0 | | 3.0 | 3.0 | 3.0 | 3.0 | 3.0 | | | | |
| | | Adipic acid | | 3.0 | | 3.0 | | | | | | | | | |
| | | Sebacic acid | | | 1.5 | 1.5 | | | | | | | | | |
| | | Glutaric acid | | | | | 1.5 | | | | | | | | |
| | | Diglycolic acid | | | | | | 1.5 | 1.5 | 1.5 | 1.5 | | | | |
| | Amine | Monoisopropanol amine | 0.4 | | | 0.4 | | | | | | | | | |
| | | 2-Methyl imidazole | | 0.4 | | | 0.4 | | | | | | | | |
| | | Triethylamine | | | 0.4 | | | 0.4 | 0.4 | 0.4 | 0.4 | | | | |
| | Amine hydrohalide | 1,3-Diphenylguanizine hydrobromide | | | | | | | | | | 1.5 | 1.5 | 1.5 | 1.5 |
| | | Monoethylamine hydrobromide | | | | | | | | | | | | | |
| | | Diethylamine hydrobromide | | | | | | | | | | | | | |
| | | Cyclohexylamine hydrobromide | | | | | | | | | | | | | |
| | | Monoethylamine hydrochloride | | | | | | | | | | | | | |
| | Organic bromine compound | trans-2,3-Dibromo-2-butene-1,4-diol | | | | | | | | | | | | | |
| | | 2,3-Dibromo-1,4-butane diol | | | | | | | | | | | | | |
| | Total | | 100.0 | 100.0 | 100.0 | 100.0 | 100.0 | 100.0 | 100.0 | 100.0 | 100.0 | 100.0 | 100.0 | 100.0 | 100.0 |
| | Hydrogenated acid-modified rosin (mass%)/Hydrogenated rosin (mass%) | | 2.1 | 2.1 | 2.1 | 2.1 | 2.1 | 2.1 | 3.0 | 5.0 | 33.9 | 0.0 | – | – | 0.1 |
| | Organic acid (mass%)/Rosin-based resin (mass%) | | 0.08 | 0.08 | 0.12 | 0.12 | 0.12 | 0.12 | 0.12 | 0.12 | 0.12 | – | – | – | – |
| | Amine (mass%)/Rosin-based resin (mass%) | | 0.011 | 0.011 | 0.011 | 0.011 | 0.011 | 0.011 | 0.011 | 0.011 | 0.011 | – | – | – | – |
| | Amine hydrohalide (mass%)/Rosin-based resin (mass%) | | – | – | – | – | – | – | – | – | – | 0.034 | 0.034 | 0.034 | 0.035 |
| | Organic bromine compound (mass%)/Rosin-based resin (mass%) | | – | – | – | – | – | – | – | – | – | – | – | – | – |
| | Softening point of flux (°C) | | 92.8 | 99.5 | 85.3 | 84.4 | 90.4 | 92.3 | 90.6 | 95.9 | 104.5 | 71.2 | 123.5 | 130.3 | 76.1 |

[Table 5]

Table 5

| | | | Example | | | | | | | | | Comparative Example | | | |
|---|---|---|---|---|---|---|---|---|---|---|---|---|---|---|---|
| | | | 14 | 15 | 16 | 17 | 18 | 19 | 20 | 21 | 22 | 1 | 2 | 3 | 4 |
| Flux coating layer | Rosin-based resin | Hydrogenated acrylic acid-modified rosin | 61.9% | 61.9% | 59.7% | 59.7% | 59.7% | 59.7% | 66.2% | 73.6% | 85.8% | | 96.7% | | 4.8% |
| | | Hydrogenated rosin | 29.7% | 29.7% | 28.6% | 28.6% | 28.6% | 28.6% | 22.1% | 14.7% | 2.5% | 96.7% | | | 91.7% |
| | | Polymerized rosin | | | | | | | | | | | | 96.7% | |
| | Organic acid | Suberic acid | 7.4% | | 7.2% | | 7.2% | 7.2% | 7.2% | 7.2% | 7.2% | | | | |
| | | Adipic acid | | 7.4% | | 7.2% | | | | | | | | | |
| | | Sebacic acid | | | 3.6% | 3.6% | | | | | | | | | |
| | | Glutaric acid | | | | | 3.6% | | | | | | | | |
| | | Diglycolic acid | | | | | | 3.6% | 3.6% | 3.6% | 3.6% | | | | |
| | Amine | Monoisopropanol amine | 1.0% | | | 1.0% | | | | | | | | | |
| | | 2-Methyl imidazole | | 1.0% | | | 1.0% | | | | | | | | |
| | | Triethylamine | | | 1.0% | | | 1.0% | 1.0% | 1.0% | 1.0% | | | | |
| | Amine hydrohalide | 1,3-Diphenylguanizine hydrobromide | | | | | | | | | | 3.3% | 3.3% | 3.3% | 3.3% |
| | | Monoethylamine hydrobromide | | | | | | | | | | | | | |
| | | Diethylamine hydrobromide | | | | | | | | | | | | | |
| | | Cyclohexylamine hydrobromide | | | | | | | | | | | | | |
| | | Monoethylamine hydrochloride | | | | | | | | | | | | | |
| | Organic bromine compound | trans-2,3-Dibromo-2-butene-1,4-diol | | | | | | | | | | | | | |
| | | 2,3-Dibromo-1,4-butane diol | | | | | | | | | | | | | |
| | Total | | 100.0% | 100.0% | 100.0% | 100.0% | 100.0% | 100.0% | 100.0% | 100.0% | 100.0% | 100.0% | 100.0% | 100.0% | 100.0% |
| | Softening point of flux coating layer (°C) | | 92.8 | 99.5 | 85.3 | 84.4 | 90.4 | 92.3 | 90.6 | 95.9 | 104.5 | 71.2 | 123.5 | 130.3 | 76.1 |
| Evaluation | Tack strength (gf) | 80°C | 44.4 | 55.0 | 67.4 | 93.6 | 57.7 | 58.0 | 14.6 | 32.0 | 28.9 | 167.0 | 3.6 | 3.8 | 181.0 |
| | | 120°C | 55.0 | 198.2 | 235.2 | 192.2 | 198.5 | 133.3 | 91.5 | 173.5 | 140.6 | 160.0 | 19.2 | 22.5 | 55.3 |
| | | 130°C | 116.1 | 113.8 | 732.5 | 144.6 | 265.6 | 251.9 | 144.5 | 126.7 | 132.6 | 142.3 | 69.9 | 53.3 | 125.2 |
| | Misalignment | | Good | Good | Good | Good | Good | Good | Good | Good | Good | Good | Poor | Poor | Good |

In the flux-coated solder preforms in Examples 1 to 22, the flux coating layer had a softening point of 80 to 120°C.

On the other hand, in the flux-coated solder preform in Comparative Examples 1, the flux coating layer had a softening point of less than 80°C. In the flux-coated solder preform in Comparative Examples 2, the flux coating layer had a softening point of more than 120°C. In the flux-coated solder preform in Comparative Examples 3, the flux coating layer had a softening point of more than 120°C. In the flux-coated solder preform in Comparative Examples 4, the flux coating layer had a softening point of less than 80°C.

As shown in the results in the Tables 2 to 5, the flux-coated solder preforms in Examples 1 to 22 had a tack strength at 80°C of 0.98 N (100 gf) or less and a tack strength at 130°C of 0.98 N (100 gf) or more. As a result, it has been found that the workability in drawing out the flux-coated solder preform from a reel is good, and misalignment of electronic components during reflow soldering is unlikely to occur due to improvement in the retainability of an electronic component during reflow soldering. Actually, the flux-coated solder preforms in Examples 1 to 22 caused no misalignment in the evaluation of misalignment.

In contrast, the flux-coated solder preforms in Comparative Examples 1 and 4 had a tack strength at 80°C of more than 0.98 N (100 gf), so that it has been found that the workability in drawing out the flux-coated solder preform from a reel is poor. Further, the flux-coated solder preforms in Comparative Examples 2 and 3 had a tack strength at 130°C of less than 0.98 N (100 gf), so that misalignment of an electronic component during reflow soldering easily occurs due to the lowered retainability of the electronic component during reflow soldering. Actually, misalignment occurred in the evaluation of misalignment.

REFERENCE SIGNS LIST

10: FLUX-COATED SOLDER PREFORM
20: SOLDER PREFORM
30: FLUX COATING LAYER
40: PRINTED CIRCUIT BOARD
50: HEAT SINK
60: ELECTRONIC COMPONENT (SIGNAL AMPLIFICATION DEVICE)
61: QFN
611: TERMINAL ELECTRODE
612: LOWER FACE ELECTRODE

**Claims**

**1.** A flux for flux-coated solder preform, having a softening point of 80 to 120°C.

**2.** The flux according to claim 1,

wherein the flux comprises a rosin-based resin comprising a hydrogenated acid-modified rosin and a hydrogenated rosin, and
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux is 0.2 to 35.

**3.** A flux-coated solder preform comprising

a solder preform and a flux coating layer present on a surface of the solder preform,
wherein the flux coating layer has a softening point of 80 to 120°C.

**4.** The flux-coated solder preform according to claim 3, wherein the flux coating layer has a tack strength of 0.98 N (100 gf) or more measured under conditions of 130°C, and a tack strength of 0.98 N (100 gf) or less measured under conditions of 80°C.

**5.** A flux-coated solder preform comprising

a solder preform and a flux coating layer present on a surface of the solder preform,
wherein the flux coating layer has a tack strength of 0.98 N (100 gf) or more measured under conditions of 130°C, and a tack strength of 0.98 N (100 gf) or less measured under conditions of 80°C.

6. The flux-coated solder preform according to any one of claims 3 to 5,

wherein the flux coating layer comprises a rosin-based resin comprising a hydrogenated acid-modified rosin and a hydrogenated rosin, and
a ratio of a content of the hydrogenated acid-modified rosin (mass%) to a content of the hydrogenated rosin (mass%) (Hydrogenated acid-modified rosin content (mass%)/Hydrogenated rosin content (mass%)) in the flux coating layer is 0.2 to 35.

7. The flux-coated solder preform according to any one of claims 3 to 6, wherein a content of the flux coating layer based on the whole flux-coated solder preform is 0.1 to 12 mass%.

8. The flux-coated solder preform according to any one of claims 3 to 7,

wherein the flux coating layer further comprises an organic acid, and
a ratio of a content of the organic acid (mass%) to a content of the rosin-based resin (mass%) (Organic acid content (mass%)/Rosin-based resin content (mass%)) in the flux coating layer is more than 0 and 0.15 or less.

9. The flux-coated solder preform according to any one of claims 3 to 8,

wherein the flux coating layer further comprises an amine, and
a ratio of a content of the amine (mass%) to a content of the rosin-based resin (mass%) (Amine content (mass%)/Rosin-based resin content (mass%)) in the flux coating layer is more than 0 and 0.1 or less.

10. The flux-coated solder preform according to any one of claims 3 to 9,

wherein the flux coating layer further comprises an amine hydrohalide, and
a ratio of a content of the amine hydrohalide (mass%) to a content of the rosin-based resin (mass%) (Amine hydrohalide content (mass%)/Rosin-based resin content (mass%)) in the flux coating layer is more than 0 and 0.2 or less.

11. The flux-coated solder preform according to any one of claims 3 to 10,

wherein the flux coating layer further comprises an organic bromine compound, and
a ratio of a content of the organic bromine compound (mass%) to a content of the rosin-based resin (mass%) (Organic bromine compound content (mass%)/Rosin-based resin content (mass%)) in the flux coating layer is more than 0 and 0.12 or less.

12. A method for mounting an electronic component on an electronic substrate comprising:

a step of disposing the flux-coated solder preform according to any one of claims 3 to 11 on the electronic substrate and disposing the electronic component on the flux-coated solder preform so as to form a laminate comprising the electronic substrate, the flux-coated solder preform and the electronic component, and
a step of heating the laminate to melt the flux coating layer and the solder preform and then cooling the laminate to solidify the solder preform for bonding the electronic substrate to the electronic component.

Fig. 1

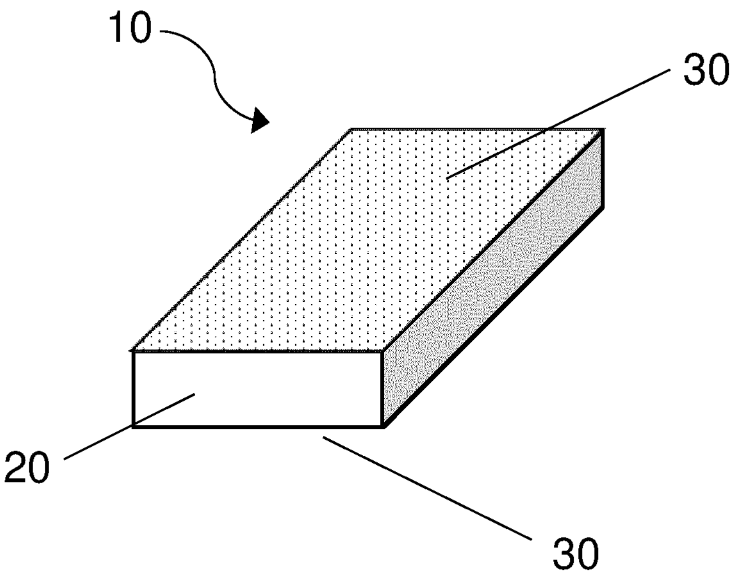

Fig. 2

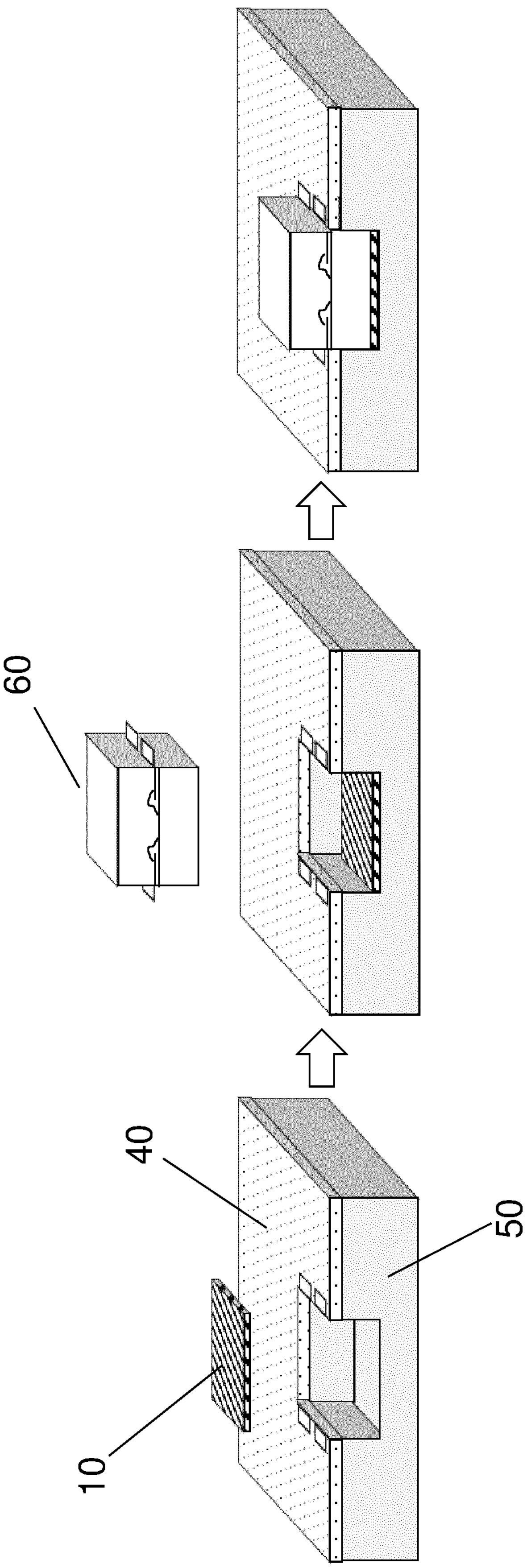

Fig. 3

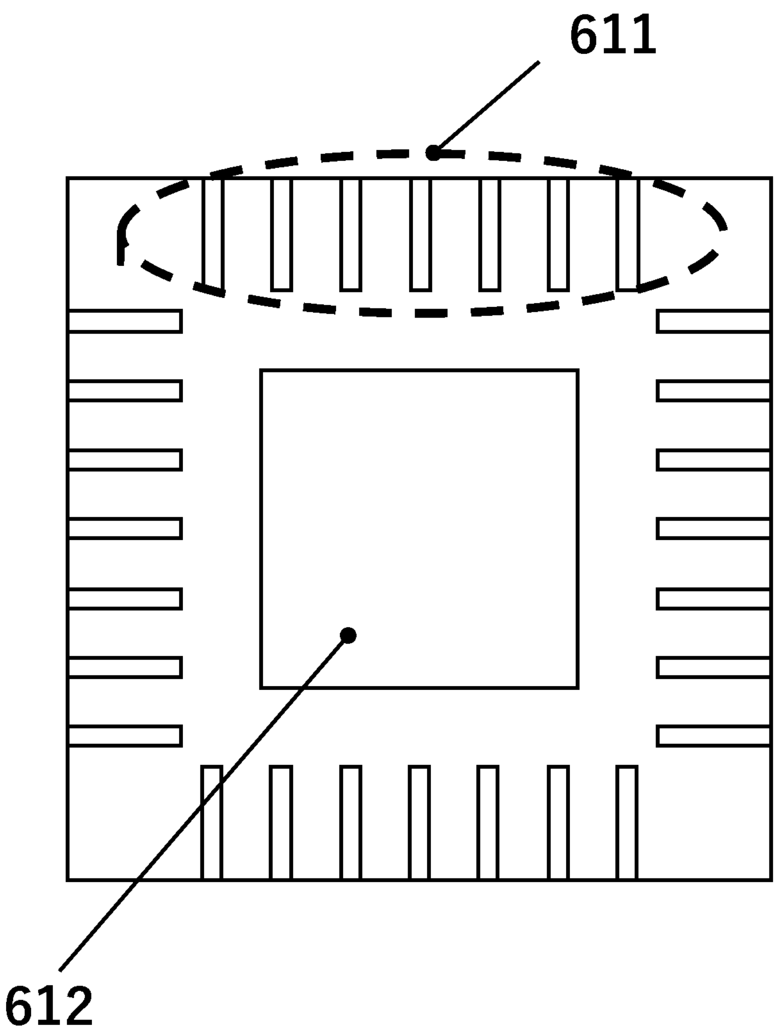

Fig. 4

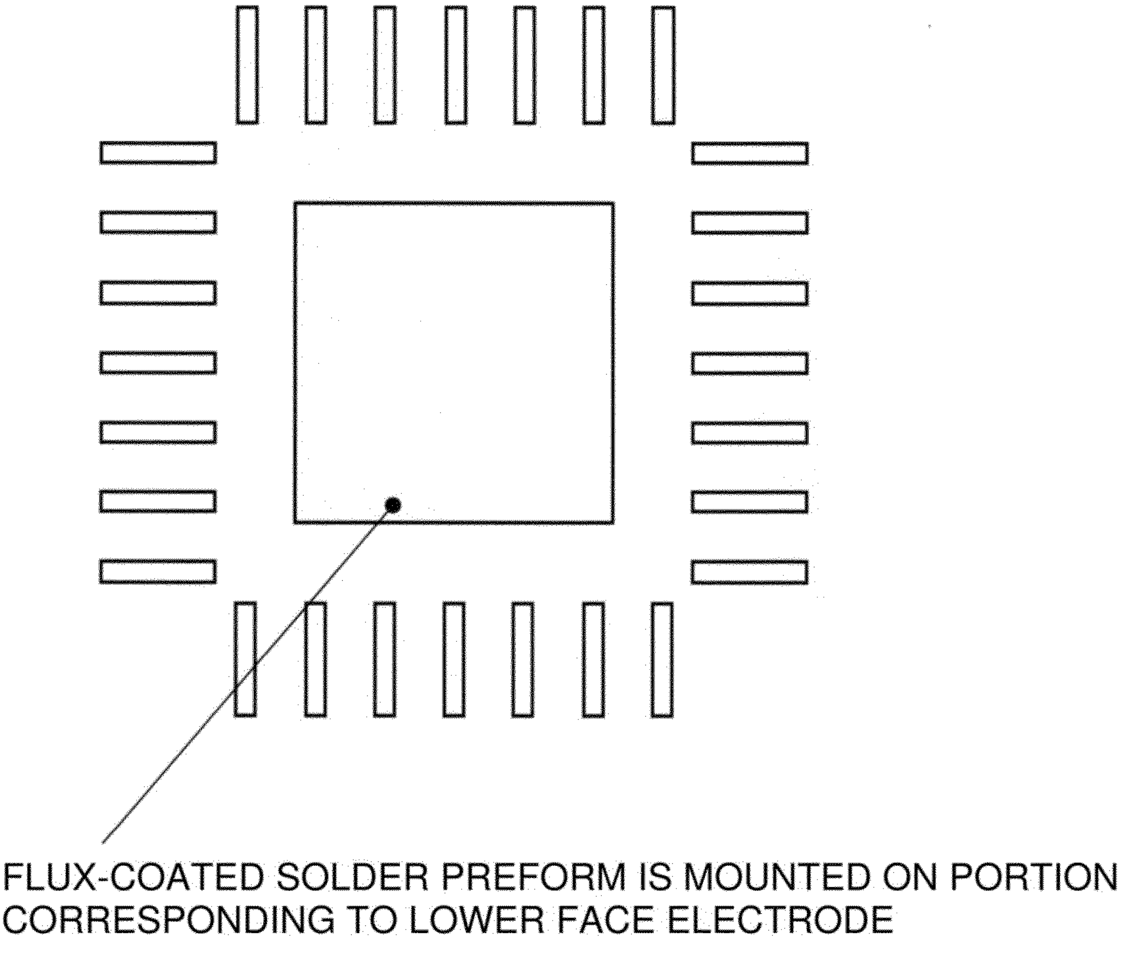
FLUX-COATED SOLDER PREFORM IS MOUNTED ON PORTION
CORRESPONDING TO LOWER FACE ELECTRODE

Fig. 5

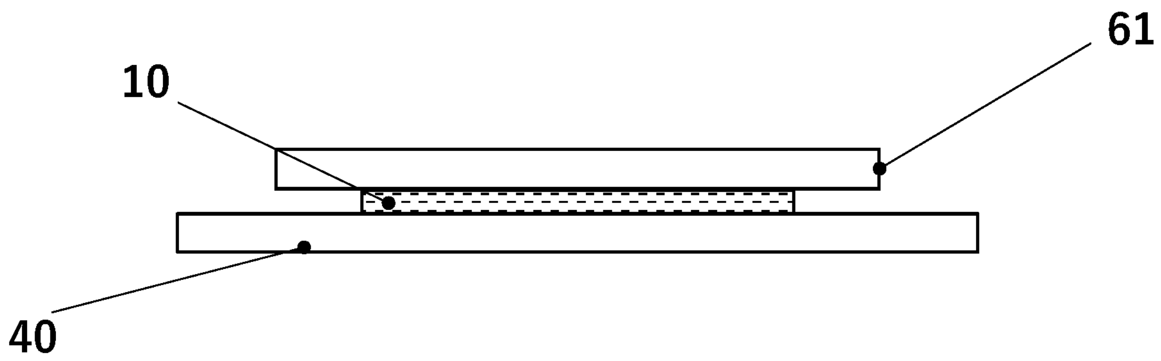

Fig. 6

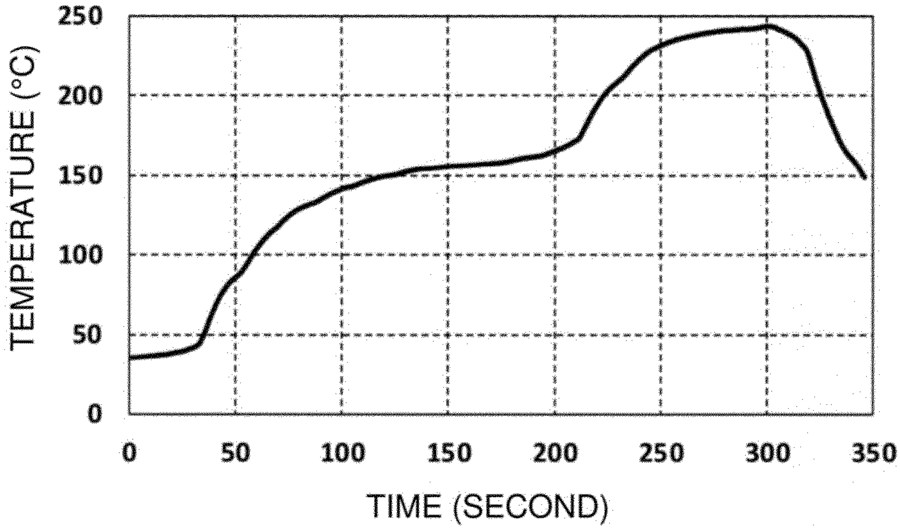
250
200
150
100
50
0
TEMPERATURE (°C)
0
50
100
150
200
250
300
350
TIME (SECOND)

Fig. 7

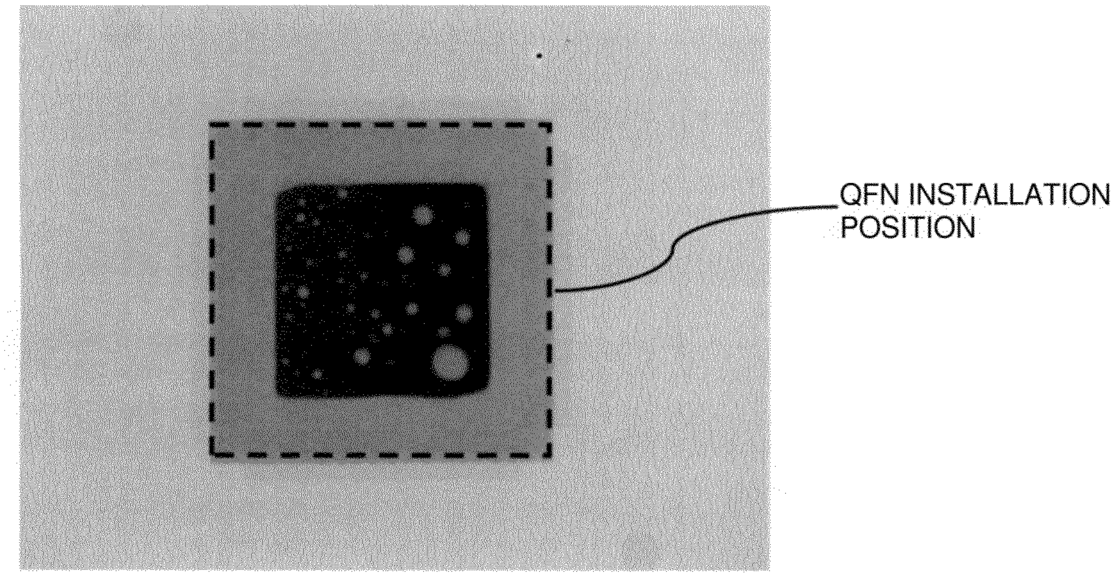


(UNACCEPTABLE)

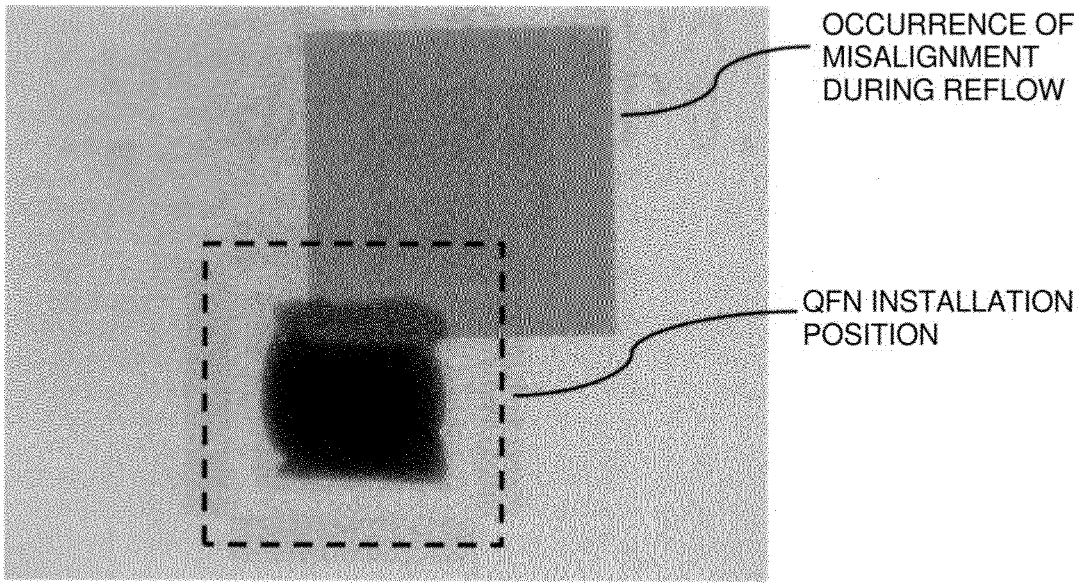

**INTERNATIONAL SEARCH REPORT**

International application No.
**PCT/JP2021/043559**

**A. CLASSIFICATION OF SUBJECT MATTER**

***C22C 13/00***(2006.01)i; ***B23K 35/14***(2006.01)i; ***B23K 35/26***(2006.01)i; ***B23K 35/363***(2006.01)i; ***H05K 3/34***(2006.01)i
FI: B23K35/363 C; B23K35/14 Z; H05K3/34 505A; B23K35/26 310A; C22C13/00

According to International Patent Classification (IPC) or to both national classification and IPC

**B. FIELDS SEARCHED**

Minimum documentation searched (classification system followed by classification symbols)

C22C13/00; B23K35/14; B23K35/26; B23K35/363; H05K3/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | CN 103817062 A (LIU, Huiling) 28 May 2014 (2014-05-28)<br>entire text | 1-12 |
| A | CN 103056556 A (ZHEJIANG ASIA GENERAL SOLDERING & BRAZING MATERIAL CO., LTD.) 24 April 2013 (2013-04-24)<br>entire text | 1-12 |
| A | JP 6795778 B1 (SENJU METAL INDUSTRY CO) 02 December 2020 (2020-12-02)<br>entire text | 1-12 |
| A | JP 2017-503658 A (ALPHA METALS, INC) 02 February 2017 (2017-02-02)<br>entire text | 1-12 |
| A | JP 2010-515576 A (FRY'S METALS, INC) 13 May 2010 (2010-05-13)<br>entire text | 1-12 |
| A | 阿部 洋樹 他, オレフィン接着性・耐応力性を向上したロジン系粘着付与樹脂の開発, HARIMA TECHNOLOGY REPORT, 19 April 2019<br>p. 3, left column, lines 15-16, (ABE, Hiroki et al. Development Trends of Rosin Type Tackifier with Improved Olefin Adhesion And Stress Resistance.) | 1-12 |

☐ Further documents are listed in the continuation of Box C.　☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 January 2022** | **08 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br><br>Telephone No. |

Form PCT/ISA/210 (second sheet) (January 2015)

**INTERNATIONAL SEARCH REPORT**
**Information on patent family members**

International application No.
**PCT/JP2021/043559**

| Patent document cited in search report | Publication date (day/month/year) | Patent family member(s) | Publication date (day/month/year) |
|---|---|---|---|
| CN 103817062 A | 28 May 2014 | (Family: none) | |
| CN 103056556 A | 24 April 2013 | (Family: none) | |
| JP 6795778 B1 | 02 December 2020 | (Family: none) | |
| JP 2017-503658 A | 02 February 2017 | EP 3068576 A1<br>KR 10-2016-0081924 A<br>CN 105813795 A | |
| JP 2010-515576 A | 13 May 2010 | US 2010/0139952 A1<br>WO 2008/085570 A2<br>EP 2106318 A2<br>CA 2677102 A1<br>KR 10-2009-0099008 A<br>CN 101622094 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2010515576 A